# EUROPÄISCHE PATENTSCHRIFT

(11) **EP 1 963 877 B1**
(45) Veröffentlichungstag und Bekanntmachung des Hinweises auf die Patenterteilung: **03.06.2009**
(21) Anmeldenummer: 06829749.8
(22) Anmeldetag: 19.12.2006
(51) Int. Cl.: G01R 33/06, G01R 33/07, G01R 33/09

(54) **MAGNETFELDSENSORANORDNUNG UND VERFAHREN ZUR BERÜHRUNGSLOSEN MESSUNG EINES MAGNETFELDES**
MAGNETIC FIELD SENSOR ARRANGEMENT AND METHOD FOR NON-CONTACT MEASUREMENT OF A MAGNETIC FIELD
DISPOSITIF DE DETECTION DE CHAMP MAGNETIQUE ET PROCEDE DE MESURE SANS CONTACT DE CHAMP MAGNETIQUE

(30) Priorität: 19.12.2005 DE 102005060713
(43) Veröffentlichungstag der Anmeldung: 03.09.2008
(73) Patentinhaber: Austriamicrosystems AG, 8141 Unterpremstätten (AT)
(72) Erfinder: ABWA, Sari, A-8302 Edelsgrub (AT); BRANDL, Manfred, A-8112 Gratwein (AT); JANISCH, Josef, A-8262 Ilz (AT)
(74) Vertreter: Epping - Hermann - Fischer
(86) Internationale Anmeldenummer: PCT/EP2006/012267
(87) Internationale Veröffentlichungsnummer: WO 2007/071383

(56) Entgegenhaltungen:
- EP-A- 1 363 134
- EP-A- 1 574 870
- EP-A2- 0 544 479
- DE-A1- 19 744 050
- US-A- 5 525 901
- US-A- 6 025 979
- US-A1- 2005 007 694

## Beschreibung

Die vorliegende Erfindung betrifft eine Magnetfeldsensoranordnung, eine Verwendung der Magnetfeldsensoranordnung sowie ein Verfahren zur berührungslosen Messung eines Magnetfeldes.

Sensoranordnungen zur Bestimmung eines Magnetfeldes werden unter anderem eingesetzt, um Winkel- oder Längeninformationen zu ermitteln. Beispielhafte Anwendungen in der Automobiltechnik sind eine elektronische Bestimmung der Gaspedalstellung, englisch e-gas pedal position, eine elektronische Bestimmung von Ventilstellungen, englisch e-gas throttle feedback, ein elektronisches Steuerrad, englisch steer by wire, sowie eine elektronische Bestimmung der Schalthebelposition, englisch gear stick position control. Bei diesen Anwendungen ist ein sehr hohes Niveau der Sicherheit zu erreichen. Ein Ausfall bei derartigen Anwendungen kann fatale Fehler verursachen. Um die Ausfallsicherheit zu verbessern, können zwei Sensoren nebeneinander platziert werden. Dabei kann der Fall auftreten, dass ein Magnet nicht in der Idealposition für jeden der beiden Sensoren angeordnet werden kann und damit eine Genauigkeit der Magnetfeldbestimmung reduziert ist. Aufgrund eines hohen Platzbedarfs sind die Einsatzmöglichkeiten eingeschränkt.

Das Dokument US-A-6 025 979 offenbart eine Magnetfeldsensoranordnung umfassend eine Stapelanordnung mit zwei Magnetfeldsensorkörpern, die sowohl ein magnetfeldsensitives Element als auch eine Magnetfeldauswerteschaltung aufweisen.

Die Dokumente EP-A-1 363 134, EP-A-1 574 870 und US 2005/007694 beschreiben ebenfalls Magnetfeldsensoranordnungen.

Das Dokument US-A-5 525 901 zeigt zwei Sensoren A und B, die übereinander angeordnet sind. Die Auswerteschaltungen für den Sensor A und für den Sensor B sind getrennt von den beiden Sensoren A, B realisiert.

Aufgabe der vorliegenden Erfindung ist es, eine Magnetfeldsensoranordnung und ein Verfahren zur berührungslosen Messung eines Magnetfeldes bereitzustellen, bei dem die Ausfallsicherheit und die Genauigkeit erhöht ist und die Magnetfeld-sensoranordnung gegenüber einem Magnetfeld zentriert und mit kleinerem Platzbedarf realisiert werden kann.

Diese Aufgaben werden mit dem Gegenstand des Patentanspruchs 1 sowie dem Verfahren gemäß dem Patentanspruch 11 gelöst. Weiterbildungen und Ausgestaltungen sind jeweils Gegenstand der abhängigen Ansprüche.

Erfindungsgemäß umfasst die Magnetfeldsensoranordnung eine Stapelanordnung. Die Stapelanordnung weist einen ersten Magnetfeldsensorkörper und einen zweiten Magnetfeldsensorkörper auf. Der erste Magnetfeldsensorkörper weist eine erste Hauptfläche mit einem ersten magnetfeldsensitiven Element und eine zweite Hauptfläche auf. Die zweite Hauptfläche ist näherungsweise parallel zu der ersten Hauptfläche. Entsprechend weist der zweite Magnetfeldsensorkörper eine erste Hauptfläche mit einem zweiten magnetfeldsensitiven Element und eine zweite Hauptfläche auf. Auch die zweite Hauptfläche des zweiten Magnetfeldsensorkörpers ist näherungsweise parallel zu der ersten Hauptfläche des zweiten Magnetfeldsensorkörpers. Unter der Stapelanordnung wird hier verstanden, dass der erste Magnetfeldsensorkörper und der zweite Magnetfeldsensorkörper in einer Projektionsrichtung, welche senkrecht zu ihren ersten und zweiten Hauptflächen ist, übereinander angeordnet sind.

Ein Magnetfeld wirkt somit sowohl auf den ersten wie auch auf den zweiten Magnetfeldsensorkörper. Da beide Magnetfeldsensorkörper jeweils ein magnetfeldsensitives Element aufweisen, wird das Magnetfeld redundant bestimmt.

Mit Vorteil ist somit die Ausfallsicherheit gegenüber einem einzelnen magnetfeldsensitiven Element erhöht. Es ist ein Vorteil der Anordnung der Magnetfeldsensorkörper übereinander, dass beide Magnetfeldsensorkörper zentriert gegenüber einem Magnetfeld angeordnet sein können.

In einer Ausführungsform können das erste und/oder das zweite magnetfeldsensitive Element als magnetfeldsensitiver Feldeffekttransistor ausgebildet sein.

In einer alternativen Ausführungsform sind das erste und/oder das zweite magnetfeldsensitive Element als Hallstruktur ausgebildet. Das erste und/oder das zweite magnetfeldsensitive Element kann einen Halbleiter wie beispielsweise Indium Antimonit InSb, Indium Arsenit InAs oder Gallium Arsenit GaAs aufweisen. Mit Vorteil weist das erste und/oder das zweite magnetfeldsensitive Element Silizium als Halbleitermaterial auf. Es ist ein Vorteil von Silizium, dass in einem Halbleiterkörper aus Silizium analoge und digitale Schaltkreise einer ersten und/oder einer zweiten Magnetfeldauswerteschaltung zur Auswertung eines oder mehrerer Signale des ersten und/oder des zweiten magnetfeldsensitiven Elements realisierbar sind. Mit Vorteil weisen Hallstrukturen eine höhere Empfindlichkeit als magnetempfindliche Feldeffekttransistoren auf.

In einer alternativen Ausführungsform kann das erste und/oder das zweite magnetfeldsensitive Element zur Nutzung des magnetoresistiven Effekts ausgelegt sein. Dazu können das erste und/oder das zweite magnetfeldsensitive Element binäre und/oder ternäre Legierungen aus Nickel, Eisen oder Kobalt umfassen. Bevorzugt kann das erste und/oder das zweite magnetfeldsensitive Element Permalloy umfassen. Permalloy kann beispielsweise eine Verbindung von 81 % Nickel und 19 % Eisen aufweisen.

In einer weiteren alternativen Ausführungsform ist das erste und/oder das zweite magnetfeldsensitive Element als Giant-Magnetic-Resistor Struktur oder als Anisotropic-Magnetic-Resistor Struktur ausgebildet. Zur Bestimmung des Magnetfelds gemäß dem Giant-Magnetic-Resistor Effekt kann das erste und/oder das zweite magnetfeldsensitive Element beispielsweise Mehrfachschichten aus Eisen und Chrom, Mehrfachschichten aus Kobalt und Kupfer, Kobalt/Kupfer Filme oder Kobalt/Silber Filme umfassen.

In einer Weiterbildung kann der erste Magnetfeldsensorkörper ein erstes Magnetsensorarray umfassen. Ein Magnetsensorarray kann auch als Multisensoranordnung mehrerer magnetfeldsensitiver Elemente bezeichnet sein. Das erste Magnetsensorarray kann das erste magnetfeldsensitive Element und mindestens ein weiteres magnetfeldsensitives Element umfassen.

In einer Weiterbildung kann der zweite Magnetfeldsensorkörper ein zweites Magnetsensorarray umfassen. Das zweite Magnetsensorarray kann das zweite magnetfeldsensitive Element und mindestens ein weiteres magnetfeldsensitives Element aufweisen.

Es ist ein Vorteil von Magnetsensorarrays, dass dadurch die Anzahl von sensitiven Elementen und damit die Anzahl der Ausgangssignale der Magnetfeldsensorkörper erhöht werden kann und somit eine Sicherheit gegenüber Ausfall gesteigert werden kann. Es ist ein Vorteil von Magnetsensorarrays mit linear oder polar angeordneten magnetfeldsensitiven Elementen, dass mit ihnen eine Winkel-, Positions- oder Längeninformation ermittelbar ist.

In einer Ausführungsform ist die zweite Hauptfläche des ersten Magnetfeldsensorkörper der ersten Hauptfläche des zweiten Magnetfeldsensorkörpers zugewandt. In dieser Ausführungsform sind somit die ersten Hauptflächen beider Magnetfeldsensorkörper in der Richtung eines Magnetfeldes ausrichtbar. Mit zugewandt wird bezeichnet, dass die zweite Hauptfläche des ersten Magnetfeldsensorkörpers unmittelbar auf der ersten Hauptfläche des zweiten Magnetfeldsensorkörpers angeordnet oder von ihr durch eine oder mehrere Schichten oder durch einen oder mehrere Körper beabstandet ist. Einander zugewandtes Hauptflächen weisen Flächennormalen auf, die in entgegengesetzte Richtung weisen.

In einer alternativen Ausführungsform ist die zweite Hauptfläche des ersten Magnetfeldsensorkörpers der zweiten Hauptfläche des zweiten Magnetfeldsensorkörpers zugewandt. In dieser Ausführungsform können somit die ersten Hauptflächen der beiden Magnetfeldsensorkörper die außen.liegenden Flächen der Stapelanordnung sein. Bei dieser Ausführungsform kann der Abstand der ersten Hauptflächen größer als in der vorhergehenden Ausführungsform sein.

In einer weiteren alternativen Ausführungsform ist die erste Hauptfläche des ersten Magnetfeldsensorkörpers der ersten Hauptfläche des zweiten Magnetfeldsensorkörpers zugewandt. Die beiden zweiten Hauptflächen der beiden Magnetfeldsensorkörper können in dieser Ausführungsform die äußeren Flächen der Stapelanordnung bilden. Der Abstand der beiden ersten Hauptflächen ist in dieser Ausführungsform somit geringer als in den beiden vorhergehenden-Ausführungsformen. Es ist ein Vorteil dieser Ausführungsform, dass die magnetfeldsensitiven Elemente auf den ersten Hauptflächen sowie analoge und digitale Schaltkreise der Magnetfeldauswerteschaltungen zur Verarbeitung der Ausgangssignale der magnetfeldsensitiven Elemente geschützt sind, dadurch dass beide ersten Hauptflächen in der Stapelanordnung innenliegende Hauptflächen sind.

In einer Weiterbildung weist die Stapelanordnung einen Albstandskörper auf, der zwischen dem ersten Magnetfeldsensorkörper und dem zweiten Magnetfeldsensorkörper angeordnet ist. Der Abstandskörper kann eine erste und eine zweite Hauptfläche aufweisen, die näherungsweise parallel zueinander sind. Der Abstandskörper kann bevorzugt ein Material oder mehrere Materialien umfassen, die keinen wesentlichen Einfluss auf ein Magnetfeld aufweisen. Aufgrund einer derartigen Materialwahl ist mit Vorteil das Magnetfeld am Ort des ersten magnetfeldsensitiven Elements näherungsweise gleich dem Magnetfeld am Ort des zweiten magnetfeldsensitiven Elements.

Der Abstandskörper kann einen Umriss aufweisen derart, dass Kontaktstellen auf der ersten Hauptfläche des ersten Magnetfeldsensorkörpers und/oder der ersten Hauptfläche des zweiten Magnetfeldsensorkörpers freigelassen sind. Es ist ein Vorteil dieser Ausführungsform, dass Verbindungen zu den Kontaktstellen eines der beiden Magnetfeldsensorkörper ohne Behinderung durch den Abstandskörper oder den anderen Magnetfeldsensorkörper angeordnet sein können.

In einer Ausführungsform umfasst der Abstandskörper einen Halbleiterkörper. Der Halbleiterkörper kann in einer Ausführungsform aus einer gedünnten Scheibe eines Halbleitermaterials hergestellt sein. Es ist ein Vorteil der Herstellung des Abstandskörpers aus einer Scheibe oder aus einer gedünnten Scheibe eines Halbleitermaterials, dass die beiden Hauptflächen des Abstandskörpers näherungsweise parallel sind, dass die beiden Hauptflächen sehr eben sind und dass die Verunreinigungen in dem Halbleitermaterial sehr gering sind. Es ist ein weiterer Vorteil, dass ein Halbleitermaterial für den Abstandskörper wählbar ist, welches dasselbe Halbleitermaterial wie das Material des ersten und des zweiten Magnetfeldsensorkörpers ist, sodass die thermischen-Ausdehnungskoeffizienten des Abstandskörpers und der beiden Magnetfeldsensorkörper nahezu identisch sind und somit eine mechanische Belastung bei Temperaturänderungen gering gehalten ist. Mit Vorteil umfasst der Abstandskörper Silizium als Material.

Der erste Magnetfeldsensorkörper kann einen Halbleiterkörper aus einer gedünnten Scheibe eines Halbleitermaterials aufweisen. Entsprechend kann der zweite Magnetfeldsensorkörper einen Halbleiterkörper aus einer gedünnten Scheibe eines Halbleitermaterials aufweisen. Es ist ein Vorteil der Verwendung von gedünnten Scheiben, dass die Dicke der Stapelanordnung und die Abstände der beiden magnetfeldsensitiven Elemente zu einem Magneten einstellbar sind und geringe Abstände realisierbar sind. In einer Ausführungsform sind der erste und der zweite Magnetfeldsensorkörper derart gedünnt, dass der erste und der zweite Magnetfeldsensorkörper biegbar sind. Dazu kann in einer Ausführungsform für den ersten und für den zweiten Magnetfeldsensorkörper eine Dicke im Bereich von einigen 10 Mikrometern bis einigen 100 Mikrometern gewählt sein.

Mit Vorteil sind der erste Magnetfeldsensorkörper und der zweite Magnetfeldsensorkörper aus demselben Halbleitermaterial hergestellt. Mit Vorteil umfassen die beiden Magnetfeldsensorkörper Silizium als Material.

In einer Weiterbildung weist die Stapelanordnung einen Trägerkörper auf, der zwischen dem ersten Magnetfeldsensorkörper und dem zweiten Magnetfeldsensorkörper angeordnet ist. In dieser Ausführungsform ist der Trägerkörper innenliegend in der Stapelanordnung.

Ein Trägerkörper kann Leitungen und Anschlüsse zum Zuführen einer Versorgungsspannung an den ersten und/oder den zweiten Magnetfeldsensorkörper sowie zur elektrischen Verbindung der beiden Magnetsensorkörper untereinander und zum Abführen von Signalen der beiden Magnetsensorkörper umfassen.

In einer alternativen Ausführungsform umfasst die Stapelanordnung einen Trägerkörper, der an einer äußeren Hauptfläche eines Stapels aus dem ersten und dem zweiten Magnetfeldsensorkörper oder alternativ aus dem ersten Magnetfeldsensorkörper, dem Abstandskörper und dem zweiten Magnetfeldsensorkörper angeordnet ist. Der Trägerkörper kann somit an derjenigen Hauptfläche des zweiten Magnetfeldsensorkörpers angeordnet sein, welche weiter von dem ersten Magnetfeldsensorkörper entfernt ist. Alternativ kann der Trägerkörper an derjenigen Hauptfläche des ersten Magnetfeldsensors angeordnet sein, welche weiter von dem zweiten Magnetfeldsensorkörper entfernt ist.

In einer Weiterbildung umfasst der erste Magnetfeldsensorkörper eine erste Magnetfeldauswerteschaltung, an der ausgangsseitig ein erstes magnetfeldempfindliches Signal abgreifbar ist. Das erste magnetfeldempfindliche Signal kann ein erstes digital kodiertes Signal sein. Alternativ kann das erste magnetfeldsensitive Signal ein erstes Analogsignal sein. In einer weiteren alternativen Ausführungsform kann die erste Magnetfeldauswerteschaltung derart ausgelegt sein, dass ausgangsseitig ein erstes digital kodiertes Signal und ein erstes Analogsignal abgreifbar ist. Entsprechend kann der zweite Magnetfeldsensorkörper eine zweite Magnetfeldauswerteschaltung aufweisen, an der ausgangsseitig ein zweites magnetfeldempfindliches Signal abgreifbar ist. Das zweite magnetfeldsensitive Signal kann ein zweites digital kodiertes Signal und/oder ein zweites Analogsignal umfassen. Das erste magnetfeldsensitive Signal kann in Abhängigkeit eines Signals des ersten magnetfeldsensitiven Elements bereitgestellt sein. Entsprechend kann das zweite magnetfeldsensitive Signal in Abhängigkeit eines Signals des zweiten magnetfeldsensitiven Elements bereitgestellt sein.

In einer Ausführungsform sind die ersten Magnetfeldauswerteschaltung auf der ersten Hauptfläche des ersten Magnetfeldsensorkörpers, und die zweite Magnetfeldauswerteschaltung auf der ersten Hauptfläche des zweiten Magnetfeldsensorkörpers angeordnet.

In einer Ausführungsform kann die erste Magnetfeldäuswerteschaltung mit dem ersten magnetfeldsensitiven Element oder alternativ mit dem ersten Magnetsensorarray gekoppelt sein. Entsprechend kann die zweite Magnetfeldauswerteschaltung mit dem zweiten magnetfeldsensitiven Element oder alternativ mit dem zweiten Magnetsensorarray gekoppelt sein.

In einer weiteren Ausführungsform des ersten und/oder des zweiten Magnetfeldsensorkörpers, umfassend das erste beziehungsweise das zweite Magnetsensorarray, kann die erste beziehungsweise die zweite Magnetfeldauswerteschaltung jeweils mehrere Analogsignale und/oder mehrere digital kodierte Signale bereitstellen.

In einer Ausführungsform sind im ersten Magnetfeldsensorkörper das erste Magnetsensorarray und die erste Magnetfeldauswerteschaltung monolithisch integriert sowie im zweiten Magnetfeldsensorkörper das zweite Magnetsensorarray und die zweite Magnetfeldauswerteschaltung monolithisch integriert.

Der erste Magnetfeldsensorkörper und der zweite Magnetfeldsensorkörper können derart ausgelegt sein, dass jeder der beiden Magnetfeldsensorkörper gegenüber im Wesentlichen dieselben Komponenten eines gemeinsamen äußeren Magnetfeldes empfindlich ist. Dabei können die beiden Magnetfeldsensorkörper derart realisiert sein, dass jeder der beiden Magnetfeldsensorkörper die Richtung des gemeinsamen äußeren Magnetfeldes bestimmt. Bevorzugt können die beiden Magnetfeldsensorkörper die Richtung eines gemeinsamen äußeren Magnetfeldes unabhängig voneinander ermitteln. Der erste Magnetfeldsensorkörper und der zweite Magnetfeldsensorkörper können als zwei unabhängige Sensoren ausgelegt sein. Die beiden Magnetfeldsensorkörper können zwei Winkelsensoren oder alternativ zwei Positionssensoren oder alternativ zwei Längensensoren oder alternativ zwei Abstandssensoren sein. Dadurch wird mit Vorteil eine hohe Redundanz und Ausfallsicherheit erzielt.

In einer Ausführungsform ist ausgangsseitig an der ersten Magnetfeläauswerteschaltung ein erstes betriebszustandsabhängiges Diagnosesignal abgreifbar. Entsprechend kann ein zweites betriebszustandsabhängiges Diagnosesignal an der zweiten Magnetfeldauswerteschaltung abgreifbar sein. Das erste und/oder das zweite Diagnosesignal können Informationen umfassen derart, dass beispielsweise das Magnetfeld zu gering für eine Auswertung ist oder/und eine Versorgungsspannung unter einen Schwellwert-abgesunken ist oder/und dass der das Magnetfeld erzeugende Magnet eine Bewegung senkrecht zu der ersten Hauptfläche des ersten Magnetfeldsensorkörpers durchführt. Es kann eine Information in dem Diagnosesignal enthalten sein, dass von der Magnetfeldauswerteschaltung mittels eines Vergleichs von Signalen von mehreren Arrayelementen ein Ausfall eines Arrayelementes festgestellt worden ist.

In einer Weiterbildung weist die Magnetfeldsensoranordnung einen weiteren Halbleiterkörper mit einer Verknüpfungsschaltung auf. Die Verknüpfungsschaltung ist eingangsseitig mit mindestens einem Ausgang der ersten Magnetfeldauswerteschaltung und mit mindestens einem Ausgang der zweiten Magnetfeldauswerteschaltung verbunden. Die Verknüpfungsschaltung kann dazu vorgesehen sein, den oder die Signale der ersten Magnetfeldauswerteschaltung und der zweiten Magnetfeldauswerteschaltung zu vergleichen und ein Ausgangssignal mit einer Winkel-, Längen-, Abstands- oder alternativ Positionsinformation mit einer sehr hohen Zuverlässigkeit abzugeben. Die Verknüpfungsschaltung kann ausgelegt sein, auch dann ein Ausgangssignal abzugeben, wenn von vier eingangsseitig der Verknüpfungsschaltung zugeführten Signalen drei näherungsweise übereinstimmen, das vierte jedoch abweicht.

Die Stapelanordnung kann den weiteren Halbleiterkörper mit der Verknüpfungsschaltung umfassen. Alternativ kann der weitere Halbleiterkörper außerhalb der Stapelanordnung vorgesehen sein.

In einer Weiterbildung kann ein Ausgang der Verknüpfungsschaltung zur Abgabe eines Diagnosesignals der Magnetfeldsensoranordnung vorgesehen sein.

In einer Ausführungsform sind die erste Hauptfläche des ersten Magnetfeldsensorkörpers und die erste Hauptfläche des zweiten Magnetfeldsensors näherungsweise gleich groß. Dazu können die erste Hauptfläche des ersten Magnetfeldsensorkörpers und die erste Hauptfläche des zweiten Magnetfeldsensorkörpers näherungsweise gleiche geometrische Abmessungen aufweisen. Alternativ weisen die beiden Magnetfeldsensorkörper unterschiedliche Breiten und Längen auf, deren Produkt näherungsweise wiederum gleich ist.

In einer alternativen Ausführungsform können die erste Hauptfläche des ersten Magnetfeldsensorkörpers und die erste Hauptfläche des zweiten Magnetfeldsensorkörpers unterschiedlich groß sein. Es ist ein Vorteil dieser Ausführungsform, dass durch die unterschiedliche Größe Ausnehmungen vorgesehen sein können, die zur Kontaktierung von Anschlussstellen auf einer der ersten Hauptflächen vorgesehen sind.

In einer Ausführungsform kann die Magnetfeldsensoranordnung in einem Shrink Small Outline Package, abgekürzt SSOP, angeordnet sein.

In einer alternativen Ausführungsform kann die Magnetfeldsensorordnung in einem Quad Flatpack No-Lead Logic Package gehäust sein. Es ist ein Vorteil dieser Gehäuseform, dass sie sehr geringe äußere Abmessungen aufweist und aufgrund ihrer kompakten Bauweise eine hohe Zuverlässigkeit zeigt.

Der erste und/oder der zweite Magnetfeldsensorkörper können mittels einer MOS- oder CMOS-Integrationstechnik hergestellt sein. Alternativ können sie in einer Bipolar-Integrationstechnik realisiert sein.

Die Magnetfeldsensoranordnung kann eine Stapelanordnung mit mindestens einem weiteren Magnetfeldsensorkörper umfassen. Es kann ein weiterer Abstandskörper in der Stapelanordnung vorgesehen sein.

Der Trägerkörper kann als Leiterplatte, englisch printed circuit board, ausgebildet sein. Alternativ kann der Trägerkörper als flexible Folie ausgebildet sein. In einer Ausführungsform mit einem Trägerkörper aus einer flexiblen Folie und einem ersten und einem zweiten Magnetfeldsensorkörper aus einem gedünntem Halbleitermaterial kann mit Vorteil eine mechanisch flexible Stapelanordnung realisiert sein, die einen Einbau in nicht planare Formen wie etwa kreisförmig gebogene Formen ermöglicht.

Die Magnetfeldsensoranordnung kann zu der berührungslose Messung des Magnetfeldes eines rotierenden Magneten für eine Drehwinkelbestimmung verwendet werden. Dazu kann eine Drehachse des rotierenden Magneten zentriert über dem ersten und dem zweiten Magnetsensorarray angeordnet sein. Die Magnetfeldsensoranordnung kann zur berührungslosen Messung eines sich linear bewegenden Magneten für eine Ermittlung einer Längen-, Abstands- oder Positionsinformation verwendet werden. Die Magnetfeldsensoranordnung kann zur Bestimmung der Anzahl von Polen eines Polrades, das sich über der Magnetfeldsensoranordnung bewegt, verwendet werden.

Die Magnetfeldsensoranordnung kann zur berührungslosen Messung des Magnetfeldes eines stromdurchflossenen Leiters eingesetzt werden. In dieser Verwendung kann die Magnetfeldsensoranordnung zur Bestimmung einer Information über die Stärke und/oder die Frequenz und/oder die Phasenlage eines Stromes, der durch einen über oder in der Magnetfeldsensoranordnung angeordneten elektrischen Leiter fließt, verwendet werden.

Erfindungsgemäß sieht ein Verfahren zur berührungslosen Messung eines Magnetfeldes folgende Schritte vor:
- Das Magnetfeld wird mittels eines ersten Magnetfeldsensorkörpers bestimmt. Ein erstes magnetfeldsensitives Signal wird ausgangsseitig von dem ersten Magnetfeldsensorkörper bereitgestellt.
- Das Magnetfeld wird mittels eines zweiten Magnetfeldsensorkörpers bestimmt, der in einer Stapelanordnung auf dem ersten Magnetfeldsensorkörper angeordnet ist. Von dem zweiten Magnetfeldsensorkörper wird ausgangsseitig ein zweites magnetfeldabhängiges Signal abgegeben.

Mit Vorteil wird somit gemäß diesem Verfahren ein erstes und ein zweites magnetfeldabhängiges Signal abgegeben. Damit ist die Ausfallsicherheit gegenüber einer Abgabe nur eines magnetfeldsensitiven Signals erhöht.

Bevorzugt wird bei dem Bestimmen des Magnetfeldes durch den ersten Magnetfeldsensorkörper das am Ort des ersten Magnetfeldsensorkörpers vorhandene Magnetfeld ermittelt und bei dem Bestimmen des Magnetfeldes durch den zweiten Magnetfeldsensorkörper das am Ort des zweiten Magnetfeldsensorkörpers vorhandene Magnetfeld ermittelt.

In einer Ausführungsform kann das Magnetfeld am Ort des ersten Magnetfeldsensorkörpers näherungsweise gleich zu dem Magnetfeld am Ort des zweiten Magnetfeldsensorkörpers aufgrund eines geringen Abstandes des ersten zu dem zweiten Magnetfeldsensorkörper sein.

Zusammenfassend hat die Erfindung folgende Vorteile:
- Es werden zwei magnetfeldsensitive Signale bereitgestellt. Aufgrund des höheren Informationsgehalts in zwei Signalen als in einem Signal kann die Aussagesicherheit und die Genauigkeit der Magnetfeldmessung und damit die Sicherheit gegenüber einem Ausfall oder einer Fehlbestimmung erhöht werden.
- Aufgrund der Stapelanordnung sind der erste und der zweite Magnetfeldsensorkörper übereinander angeordnet und können somit gleichzeitig gegenüber dem Magnetfeld eines Magneten zentriert werden.
- Der Platzbedarf der Stapelanordnung ist gering. Die Stapelanordnung zeigt einen kompakten Aufbau, der einen Einbau in Anwendungen mit einem beschränkten freien Raum für einen Sensor ermöglicht.
- Aufgrund des kompakten Aufbaus ist die Zuverlässigkeit der Magnetfeldsensoranordnung gegenüber einem planaren Aufbau erhöht.

Die Erfindung wird nachfolgend an mehreren Ausführungsbeispielen anhand der Figuren näher erläutert. Funktions- bzw. wirkungsgleiche Körper oder Bauelemente tragen gleiche Bezugszeichen. Insoweit sich Anordnungen, Baukörper oder Schaltungsteile in ihrer Funktion entsprechen, wird deren Beschreibung nicht in jeder der folgenden Figuren wiederholt.
- Figur 1: zeigt eine beispielhafte Magnetfeldsensoranordnung.
- Figuren 2A bis 2D: zeigen Querschnitte von beispielhaften Magnetfeldsensoranordnungen mit einem ersten und einem zweiten Magnetfeldsensorkörper.
- Figuren 3A bis 3D: zeigen Querschnitte von beispielhaften Magnetfeldsensoranordnungen mit einem ersten Magnetfeldsensorkörper, einem Abstandskörper und einem zweiten Magnetfeldsensorkörper.
- Figuren 4A und 4B: zeigen eine beispielhafte Magnetfeldsensoranordnung im Querschnitt und in Aufsicht.
- Figuren 5A und 5B: zeigen weitere beispielhafte Magnetfeldsensoranordnungen.
- Figur 6: zeigt eine dreidimensionale Ansicht einer beispielhaften Magnetfeldsensoranordnung.
- Figur 7: zeigt Konturlinien, welche aus einer Fotografie eines Querschliffes extrahiert wurden, welche einen Querschnitt einer beispielhaften Magnetfeldsensoranordnung zeigt.

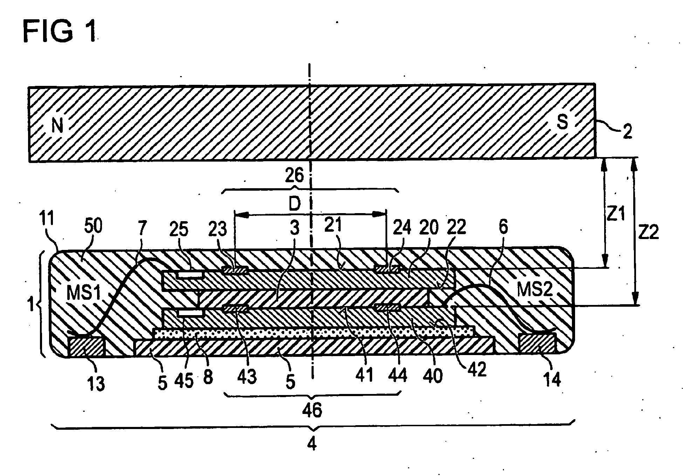

Figur 1 zeigt eine beispielhafte Ausführungsform einer Magnetfeldsensoranordnung im Querschnitt. Die Magnetfeldsensoranordnung 4 umfasst eine Stapelanordnung 1 mit einem ersten Magnetfeldsensorkörper 20, einem Abstandskörper 3, einem zweiten Magnetfeldsensorkörper 40 und einem Trägerkörper 5.

Der erste Magnetfeldsensorkörper 20 weist an einer ersten Hauptfläche 21 ein erstes Magnetsensorarray 26, umfassend mindestens ein erstes und ein weiteres magnetfeldsensitives Element 23, 24, und eine mit dem Magnetsensorarray 26 gekoppelte erste Magnetfeldauswerteschaltung 25 auf. Eine zweite Hauptfläche 22 des ersten Magnetfeldsensorkörpers 20 ist parallel zur ersten Hauptfläche 21 des ersten Magnetfeldsensorkörpers 20. Die zweite Hauptfläche 22 des ersten Magnetfeldsensorkörpers 20 ist auf dem Abstandskörper 3 angeordnet. Der Abstandskörper 3 weist zwei parallele Hauptflächen auf. Der Abstandskörper 3 ist wiederum auf einer ersten Hauptfläche 41 des zweiten Magnetfeldsensorkörpers 40 angeordnet. Auf der ersten Hauptfläche 41 des zweiten Magnetfeldsensorkörpers 40 ist ein zweites Magnetsensorarray 46 und eine zweite Magnetfeldauswerteschaltung 45 vorgesehen, welche dem zweiten Magnetsensorarray 46 nachgeschaltet ist. Das zweite Magnetsensorarray 46 umfasst mindestens ein zweites und ein weiteres magnetfeldsensitives Element 43, 44. Der zweite Magnetfeldsensorkörper 40 weist eine zweite Hauptfläche 42 auf, die parallel zu der ersten Hauptfläche 41 ausgebildet ist.

Die zweite Hauptfläche 42 des zweiten Magnetfeldsensorkörpers 40 ist auf dem Trägerkörper 5 angeordnet. Zwischen der zweiten Hauptfläche 42 des zweiten Magnetfeldsensorkörpers 40 und dem Trägerkörper 5 ist eine Verbindungsschicht 8 vorgesehen. Die Magnetfeldsensoranordnung 4 weist einen Bonddraht 7 auf, der zur Verbindung der ersten Auswerteschaltung 25 mit einem Anschluss 13 vorgesehen ist. Ein Bonddraht 6 ist zur Verbindung der zweiten Magnetfeldauswerteschaltung 45 und einem Anschluss 14 vorgesehen.

Das erste magnetfeldsensitive Element 23 hat einen Abstand D zu dem weiteren magnetfeldsensitiven Element 24 des ersten Magnetfeldsensorkörpers 20. Ebenso weist das zweite magnetfeldsensitive Element 43 des zweiten Magnetfeldsensorkörpers 40 einen Abstand D von dem weiteren magnetfeldsensitiven Element 44 des zweiten Magnetfeldsensorkörpers 40 auf.

Die erste Hauptfläche 21 des ersten Magnetfeldsensorkörpers 20 hat einen Abstand Z1 zu einem Magnet 2. Die erste Hauptfläche 41 des zweiten Magnetfeldsensorkörpers 40 weist einen Abstand Z2 zu dem Magnet 2 auf. In einer beispielhaften Ausführungsform können die beiden Abstände Z1, Z2 von einem Bereich von 0,5 mm bis 2 mm umfasst sein.

Die Stapelanordnung 1 ist mittels eines Quad Flatpack No-Lead Logic Package 11 gehäust. Das Gehäuse weist ein Polymermaterial 50 auf. Das Polymermaterial 50 ist beispielsweise ein Duroplast. Elektrisch leitende Anschlüsse 13, 14 dienen der Verbindung der Stapelanordnung 1 nach außen. Die Anschlüsse 13, 14 weisen beispielsweise Kupfer auf.

Der Magnet 2 wirkt sowohl auf die magnetfeldsensitiven Elemente 23, 24 des ersten Magnetfeldsensorkörpers 20 wie auch auf die magnetfeldsensitiven Elemente 43, 44 des zweiten Magnetfeldsensorkörpers 40. Signale, die an dem ersten und dem weiteren magnetfeldsensitiven Element 23, 24 des ersten Magnetfeldsensorkörpers 20 abgreifbar sind, werden mittels der ersten Magnetfeldauswerteschaltung 25 ausgewertet und als erstes magnetfeldsensitives Signal MS1 an dem Anschluss 13 bereitgestellt. Entsprechend werden Signale der magnetfeldsensitiven Elemente 43, 44 des zweiten Magnetfeldsensorkörpers 40 von der zweiten Magnetfeldauswerteschaltung 45 verarbeitet und ist ein zweites magnetfeldsensitives Signal MS2 an dem Anschluss 14 abgreifbar.

Mit Vorteil ist aufgrund zweier Magnetfeldsensorkörper 20, 40 und jeweils zweier magnetfeldsensitiver Elemente 23, 24, 43, 44 eine Bestimmung des Magnetfeldes mit einer hohen Sicherheit gegenüber Ausfällen ermöglicht. Mit Vorteil ist somit eine sehr kompakte Stapelanordnung 1 in einem raumsparenden Gehäuse 11 für die Magnetfeldbestimmung realisiert. Es ist ein Vorteil des Abstandskörpers 3, dass er den Abstand des ersten Magnetfeldsensorkörpers 20 zu dem zweiten Magnetfeldsensorkörper 40 so weit erhöht, dass der Bonddraht 6 seitlich weggeführt werden kann.

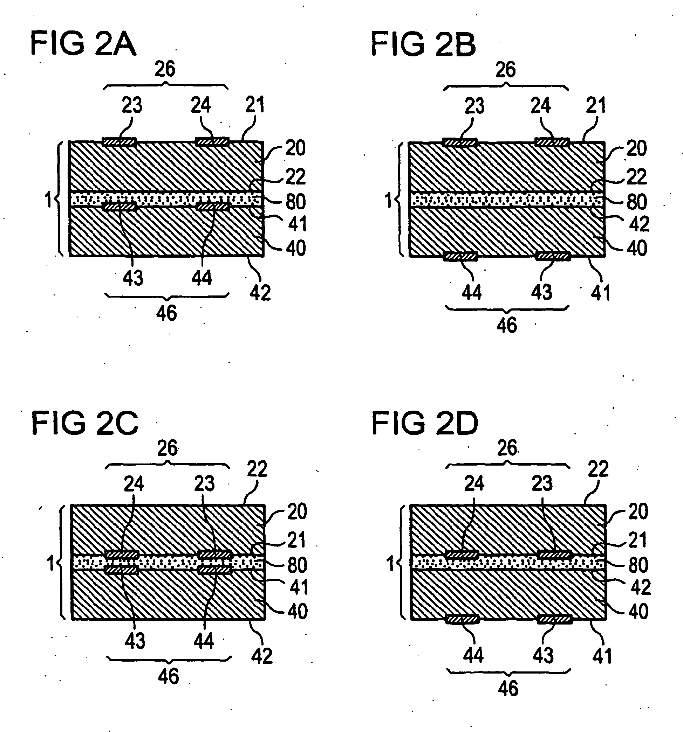

Figuren 2A bis 2D zeigen beispielhafte Stapelanordnungen mit einem ersten und einem zweiten Magnetfeldsensorkörper 20, 40 in Querschnitten.

Figur 2A zeigt eine Stapelanordnung 1 mit einem ersten und einem zweiten Magnetfeldsensorkörper 20, 40. Der erste Magnetfeldsensorkörper 20 weist eine erste Hauptfläche 21, auf der ein erstes magnetfeldsensitives Element 23 und ein weiteres magnetfeldsensitives Element 24 angeordnet ist, und eine zweite Hauptfläche 22 auf. Ein erstes Magnetsensorarray 26 umfasst das erste und das weitere magnetfeldsensitive Element 23, 24. Entsprechend weist der zweite Magnetfeldsensorkörper 40 eine erste Hauptfläche 41, auf der ein zweites magnetfeldsensitives Element 43 und ein weiteres magnetfeldsensitives Element 44 vorgesehen ist, und eine zweite Hauptfläche 42 auf. Ein zweites Magnetsensorarray 46 umfasst das zweite magnetfeldsensitive Element 43 und das weitere magnetfeldserisitive Element 44.

Die erste Hauptfläche 21 des ersten Magnetfeldsensorkörpers 20 ist näherungsweise parallel zur zweiten Hauptfläche 22 desselben. Die erste Hauptfläche 41 des zweiten Magnetfeldsensorkörpers 40 ist näherungsweise parallel zur zweiten Hauptfläche 42 desselben.

Gemäß Figur 2A ist die zweite Hauptfläche 22 des ersten Magnetfeldsensorkörpers 20 auf der ersten Hauptfläche 41 des zweiten Magnetfeldsensorkörpers 40 angeordnet. Zwischen den beiden Magnetfeldsensorkörpern 20, 40 ist eine Zwischenschicht 80 vorgesehen.

Figur 2B zeigt eine alternative Stapelanordnung 1 zu der Stapelanordnung 1 gemäß Figur 2A. Gemäß Figur 2B ist die zweite Hauptfläche 22 des ersten Magnetfeldsensorkörpers 20 an der zweiten Hauptfläche 42 des zweiten Magnetfeldsensors 40 angeordnet. Damit befinden sich die magnetfeldsensitiven Elemente 23, 24, 43, 44 an äußeren Hauptflächen der Stapelanordnung 1.

Figur 2C zeigt eine weitere alternative Stapelanordnung 1 zu den Stapelanordnungen 1 gemäß Figuren 2A und 2B. Gemäß Figur 2C ist die erste Hauptfläche 21 des ersten Magnetfeldsensorkörpers 20 auf der ersten Hauptfläche 41 des zweiten Magnetfeldsensorkörpers 40 angeordnet. Die Zwischenschicht 80 dient zur Befestigung der beiden Magnetfeldsensorkörper 40 aufeinander. Gemäß Figur 2C sind die vier magnetfeldsensitiven Elemente 23, 24, 43, 44 an innen liegenden Flächen der Stapelanordnung 1 und nicht an einer der äußeren Flächen der Stapelanordnung 1 angebracht. Mit Vorteil sind somit die magnetfeldsensitiven Elemente 23, 24, 43, 44 vor äußeren mechanischen Einwirkungen geschützt.

Figur 2D zeigt eine weitere alternative Stapelanordnung 1 zu den Stapelanordnungen 1 gemäß Figuren 2A bis 2C. Dabei ist die erste Hauptfläche 21 des ersten Magnetfeldsensorkörpers 20 auf der zweiten Hauptfläche 42 des zweiten Magnetfeldsensorkörpers 40 angeordnet. Bei einer Montage auf einem nicht gezeigten Trägerkörper 5 sind mit Vorteil die vier magnetfeldsensitiven Elemente 23, 24, 43, 44 geschützt.

In alternativen Ausführungsformen der Figuren 2A bis 2D ist auf der ersten Hauptfläche 21 des ersten Magnetfeldsensorkörpers 20 eine nicht eingezeichnete erste Magnetfeldauswerteschaltung 25 und auf der ersten Hauptfläche 41 des zweiten Magnetfeldsensorkörpers 40 eine nicht eingezeichnete zweite Magnetfeldauswerteschaltung 45 angeordnet.

In alternativen Ausführungsformen der Figuren 2A bis 2D kann ein nicht eingezeichneter Trägerkörper 5 an einer der äußeren Hauptflächen des Stapels aus dem ersten und dem zweiten Magnetfeldsensorkörper 20, 40 oder zwischen dem ersten Magnetfeldsensorkörper 20 und dem zweiten Magnetfeldsensorkörper 40 vorgesehen sein.

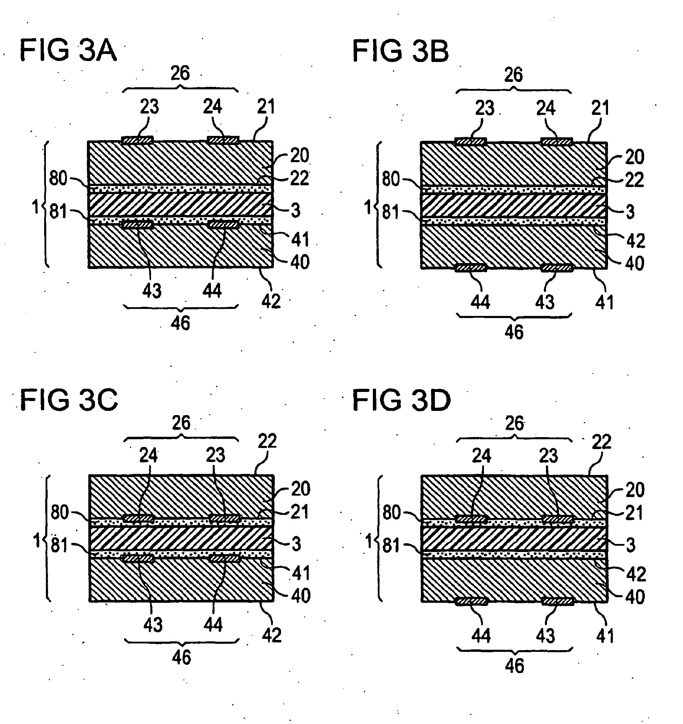

Figuren 3A bis 3D zeigen Querschnitte von beispielhaften Magnetfeldsensoranordnungen. Die Magnetfeldsensoranordnungen gemäß den Figuren 3A bis 3D sind Weiterentwicklungen der Magnetfeldsensoranordnungen gemäß der Figuren 2A bis 2D und umfassen zusätzlich zu den Mägnetfeldsensoranordnungen gemäß Figuren 2A bis 2D einen Abstandskörper 3. Der Abstandskörper 3 ist zwischen dem ersten Magnetfeldsensorkörper 20 und dem zweiten Magnetfeldsensorkörper 40 angeordnet.

Figur 3A zeigt eine Magnetfeldsensoranordnung, die eine Weiterbildung der Magnetfeldsensoranordnung gemäß Figur 2A darstellt. Die zweite Hauptfläche 22 des ersten Magnetfeldsensorkörpers 20 ist auf einem Abstandskörper 3 angeordnet, welcher wiederum auf der ersten Hauptfläche 41 des zweiten Magnetfeldsensorkörpers 40 angeordnet ist. Zwei Zwischenschichten 80, 81 dienen der Befestigung der drei Körper 20, 3, 40 zueinander.

Figur 3B zeigt eine Magnetfeldsensoranordnung, die eine Weiterbildung der Magnetfeldsensoranordnung nach Figur 2B ist. Mit Vorteil wird mittels des Abstandskörpers 3 ein größerer Abstand zwischen den magnetfeldsensitiven Elementen 23, 24 des ersten Magnetfeldsensorkörpers 20 und den magnetfeldsensitiven Elementen 43, 44 des zweiten Magnetfeldsensorkörpers 40 erzielt.

Figur 3C zeigt eine Magnetfeldsensoranordnung, welche eine Weiterbildung der Magnetfeldsensoranordnung gemäß Figur 2C darstellt. Mittels des Abstandskörpers 3 wird ein Abstand zwischen den magnetfeldsensitiven Elemente 23, 24 des ersten Magnetfeldsensorkörpers 20 und den magnetfeldsensitiven Elementen 43, 44 des zweiten Magnetfeldsensorkörpers 40 erzielt. Mit Vorteil weisen somit die magnetfeldsensitiven Elemente 23, 24, 43, 44 einen Abstand voneinander auf, sind jedoch weiterhin auf innenliegenden Flächen der Stapelanordnung 1 angeordnet und somit von äußeren mechanischen Einflüssen geschützt.

Figur 3D zeigt eine Magnetfeldsensoranordnung, die eine Weiterentwicklung der Magnetfeldsensoranordnung gemäß Figur 2D darstellt.

In alternativen Ausführungsformen der Figuren 3A bis 3D ist auf der ersten Hauptfläche 21 des ersten Magnetfeldsensorkörpers 20 eine nicht eingezeichnete erste Magnetfeldauswerteschaltung 25 und auf der ersten Hauptfläche 41 des zweiten Magnetfeldsensorkörpers 40 eine nicht eingezeichnete zweite Magnetfeldauswerteschaltung 45 angeordnet.

In alternativen Ausführungsformen der Figuren 3A bis 3D kann ein hier nicht eingezeichneter Trägerkörper 5 an einem der äußeren Hauptflächen des Stapels aus dem ersten Magnetfeldsensorkörper 20, dem Abstandskörper 3 und dem zweiten Magnetfeldsensorkörper 40 oder zwischen dem ersten Magnetfeldsensorkörper 20 und dem Abstandskörper 3 oder alternativ zwischen dem Abstandskörper 3 und dem zweiten Magnetfeldsensorkörper 40 vorgesehen sein.

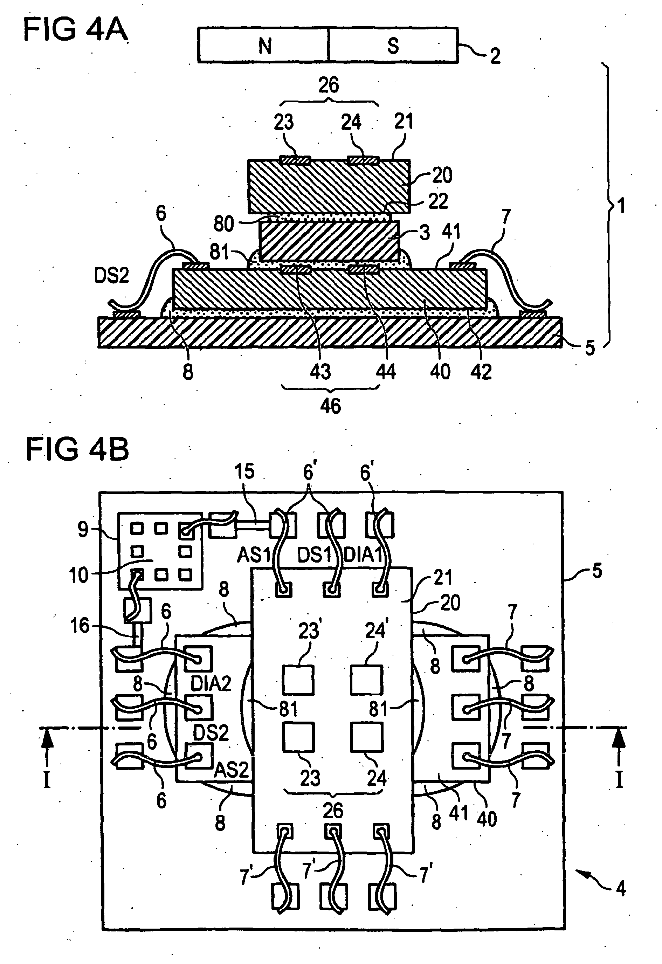

Figuren 4A und 4B zeigen eine beispielhafte Magnetfeldsensoranordnung.

Figur 4A zeigt einen Querschnitt der Magnetfeldsensoranordnung, welche eine Weiterentwicklung der Magnetfeldsensoranordnung gemäß Figur 1 und Figur 3A ist. Die Stapelanordnung 1 gemäß Figur 4A weist einen ersten Magnetfeldsensorkörper 20 auf, der eine erste Hauptfläche 21 mit einem ersten Magnetsensorarray 26 und eine zweite Hauptfläche 22 aufweist, die über eine Zwischenschicht 80 mit einem Abstandskörper 3 verbunden ist. Der Abstandskörper 3 ist über eine weitere Zwischenschicht 81 auf einer ersten Hauptfläche 41 eines zweiten Magnetfeldsensorkörpers 40 angeordnet. Eine zweite Hauptfläche 42 des zweiten Magnetfeldsensorkörpers 40 ist mittels einer Verbindungsschicht 8 auf einem Trägerkörper 5 angebracht. In Figur 4A sind die lateralen Dimensionen so gewählt, dass der erste Magnetfeldsensorkörper 20 und der Abstandskörper 3 eine kleinere laterale Dimension aufweisen, verglichen mit dem zweiten Magnetfeldsensorkörper 40. Der Trägerkörper 5 weist eine größere laterale Dimension als der zweite Magnetfeldsensorkörper 40 auf. Mit Vorteil sind somit Bonddrähte 6, 7 für eine Verbindung von Anschlüssen auf der ersten Hauptfläche 41 des zweiten Magnetfeldsensorkörpers 40 zu Anschlüssen auf dem Trägerkörper 5 vorgesehen.

Figur 4B zeigt eine Aufsicht der Magnetfeldsensoranordnung gemäß Figur 4A, in der eine Schnittlinie I angegeben ist, an welcher sich der in Figur 4A gezeigte Querschnitt befindet. Das erste Magnetsensorarray 26 umfasst vier magnetfeldsensitive Elemente 23, 23', 24, 24' auf der ersten Hauptfläche 21 des ersten Magnetfeldsensorkörpers 20. Mittels sechs Bonddrähten 6', 7' ist die erste Hauptfläche 21 des ersten Magnetfeldsensorkörpers 20 mit Anschlüssen auf dem Trägerkörper 5 verbunden. Mehrere Bonddrähte 6' sind für die Weiterleitung eines ersten analogen Signals AS1, eines ersten digitalen Signals DS1 und eines ersten Diagnosesignals DIA1 vorgesehen. Der erste Magnetfeldsensorkörper 20 ist über die Zwischenschicht 80, den Abstandskörper 3 und die weitere Zwischenschicht 81 mit dem zweiten Magnetfeldsensorkörper 40 verbunden. Es sind sechs Bonddrähte 6, 7 gezeigt, die Anschlüsse auf der ersten Hauptfläche 41 des zweiten Magnetfeldsensorkörpers 40 mit sechs Anschlüssen des Trägerkörpers 5 verbinden. Mehrere Bonddrähte 6 sind für die Weiterleitung eines zweiten analogen Signals AS2, eines zweiten digitalen Signals DS2 und eines zweiten Diagnosesignals DIA2 vorgesehen. Das zweite Magnetsensorarray 46 ist nicht gezeigt, da es sich unterhalb des ersten Magnetfeldsensorkörpers 20 befindet.

Der erste Magnetfeldsensorkörper 20 und der zweite Magnetfeldsensorkörper 40 sind als Rechtecke ausgebildet und so aufeinander angeordnet, dass die Anschlüsse auf der ersten Hauptfläche 41 des zweitenmagnetfeldsensors 40 freiliegend und nicht von dem ersten Magnetfeldsensorkörper 20 bedeckt werden. Somit ermöglicht diese Stapelanordnung 1 ein einfaches Kontaktieren mittels Bonddrähten 6, 6', 7, 7'. Der erste Magnetfeldsensorkörper 20 kann denselben Aufbau wie der zweite Magnetfeldsensorkörper 40 aufweisen. Die Magnetfeldsensoranordnung gemäß Figur 4B umfasst weiter einen Halbleiterkörper 9 mit einer Verknüpfungsschaltung 10, der auf dem Trägerkörper 5 angeordnet ist. Die Verknüpfungsschaltung 10 ist mittels Bonddrähten und Leiterbahnen 15, 16 mit den beiden Magnetfeldsensorkörpern 20, 40 verbunden.

Mit Vorteil ist somit eine Magnetfeldsensoranordnung 4 vorgesehen, deren magnetfeldsensitiven Elemente zentriert übereinander angeordnet sind.

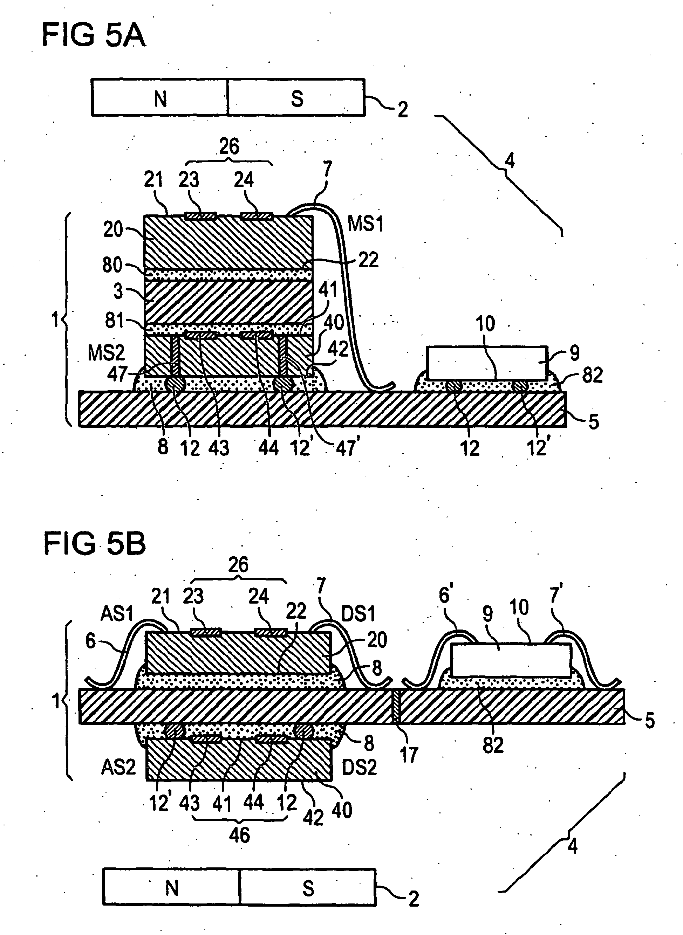

In alternativen Ausführungsformen der Figuren 5A und 5D umfasst die erste Hauptfläche 21 des ersten Magnetfeldsensorkörpers 20 eine nicht eingezeichnete erste Magnetfeldauswerteschaltung 25, welche zwischen das erste Magnetsensorarray 26 und die Bondrähte 6', 7' geschaltet ist. Entsprechend umfasst die erste Hauptfläche 41 des zweiten Magnetfeldsensorkörpers 40 eine nicht eingezeichnete zweite Magnetfeldauswerteschaltung 45, die zwischen das zweite Magnetsensorarray 46 und die Bonddrähte 6, 7 geschaltet ist.

Figur 5A zeigt eine beispielhafte Magnetfeldsensoranordnung im Querschnitt. Sie stellt eine weitere Weiterbildung der Magnetfeldsensoränordnung gemäß den Figuren 1, 3A, 4A und 4B dar. Die zweite Hauptfläche 22 des ersten Magnetfeldsensorkörpers 20 ist mittels der Zwischenschicht 80 auf dem Abstandskörper 3 angeordnet. Der Abstandskörper 3 ist wiederum über die weitere Zwischenschicht 81 mit der ersten Hauptfläche 41 des zweiten Magnetfeldsensorkörpers 40 verbunden. Leitende Verbindungen 47, 47' sind zur Verbindung der ersten Hauptfläche 41 mit der zweiten Hauptfläche 42 des zweiten Magnetfeldsensorkörpers 40 vorgesehen. Die leitenden Verbindungen 47, 47' sind als Durchkontaktierungen, englisch Vias ausgebildet. Es sind Löthöcker, englisch Bumps 12, 12' vorgesehen, um die leitenden Verbindungen 47, 47' mit nicht gezeigten Anschlüssen auf dem Trägerkörper 5 elektrisch leitend zu verbinden. Die Verbindungsschicht 8 zwischen der zweiten Hauptfläche 42 des zweiten Magnetfeldsensorkörpers 40 und dem Trägerkörper 5 ist zur mechanischen Befestigung vorgesehen.

Mittels eines Bonddrahtes 7 ist die erste Hauptfläche 21 des ersten Magnetfeldsensorkörpers 20 an einen Anschluss auf dem Träger 5 elektrisch leitend angeschlossen. Auf dem Trägerkörper 5 befindet sich ein Halbleiterkörper 9 mit einer Verknüpfungsschaltung 10. Die Verknüpfungsschaltung 10 ist ebenfalls mittels Löthöcker 12, 12' elektrisch leitend mit Anschlüssen auf dem Trägerkörper 5 verbanden. Zur mechanischen Befestigung dient eine weitere Verbindungsschicht 82 zwischen dem Halbleiterkörper 9 und dem Trägerkörper 5. Die beiden Verbindungsschichten 8, 82 können im Englischen als Underfiller bezeichnet werden.

Es ist ein Vorteil der Stapelanordnung 1 gemäß Figur 5A, das mittels leitenden Verbindungen in 47, 47' innerhalb des zweiten Magnetfeldsensorkörpers 40 eine elektrische Kontaktierung von der zweiten Hauptfläche 42 des zweiten Magnetfeldsensorkörpers 40 ermöglicht ist. Gemäß der Magnetfeldsensoranordnung 4 nach Figur 5A weisen der erste und der zweite Magnetfeldsensorkörper 20, 40 sowie der Abstandskörper 3 die gleichen lateralen Abmessungen auf. Der Stapel aus dem ersten Magnetfeldsensorkörper 20, dem Abstandskörper 3 und dem zweiten Magnetfeldsensorkörper 40 kann mit Vorteil im Wafer-Verbund hergestellt werden. Erst nach der Herstellung im Wafer-Verbund werden die einzelnen Stapelanordnungen 1 aus diesen drei Körpern 20, 3, 40 mittels Sägen hergestellt.

Mit Vorteil werden somit Einzelschritte zur chipweisen Verbindung von verschiedenen Körpern reduziert.

Figur 5B zeigt eine weitere beispielhafte Magnetfeldsensoranordnung im Querschnitt. Diese Magnetfeldsensoranordnung 4 ist eine Weiterbildung der Magnetfeldsensoranordnung gemäß Figur 2A. Die zweite Hauptfläche 22 des ersten Magnetfeldsensorkörpers 20 ist mittels einer Verbindungsschicht 8 mit dem Trägerkörper 5 verbunden. Die erste Hauptfläche 41 des zweiten Magnetfeldsensorkörpers 40 ist über eine weitere Verbindungsschicht 8 mit einer zweiten Hauptfläche des Trägerkörpers 5 verbunden. Bonddrähte 6, 7 sind zur elektrisch leitenden Verbindung der ersten Hauptfläche 21 des ersten Magnetfeldsensorkörpers 20 mit nicht gezeigten Anschlüssen auf der ersten Hauptfläche des Trägerkörpers 5 vorgesehen.

Löthöcker 12, 12' sind zur Realisierung einer elektrisch leitenden Verbindung von der ersten Hauptfläche 41 des zweiten Magnetfeldsensorkörpers 40 zu nicht gezeigten Anschlüssen auf der zweiten Hauptfläche des Trägerkörpers 5 vorgesehen. Ein Halbleiterkörper 9 mit einer Verknüpfungsschaltung 10 ist ebenfalls mittels einer weiteren Verbindungsschicht 82 auf der ersten Hauptfläche des Trägerkörpers 5 aufgebracht. Bonddrähte 6', 7' dienen zur Kontaktierung der Verknüpfungsschaltung 10 mit nicht gezeigten Anschlüssen auf der ersten Hauptfläche des Trägerkörpers 5. Eine Durchkontaktierung 17 ist zur Verbindung der ersten Hauptfläche zu der zweiten Hauptfläche des Trägerkörpers 5 vorgesehen. Figur 5B zeigt weiter einen Magneten 2, der zentriert zu dem ersten und dem zweiten Magnetsensorarray 26, 46 angeordnet ist.

Mit Vorteil ist somit eine kompakte Magnetfeldsensoranordnung vorgesehen, die vier magnetfeldsensitive Elemente 23, 24, 43, 44 und zwei Magnetfeldauswerteschaltungen 25, 45 sowie eine Verknüpfungsschaltung 10 aufweist. Aufgrund der Redundanzen kann mit Vorteil ein Ausgangssignal mit einer hohen Sicherheit gegenüber Störungen oder Ausfällen abgegeben werden.

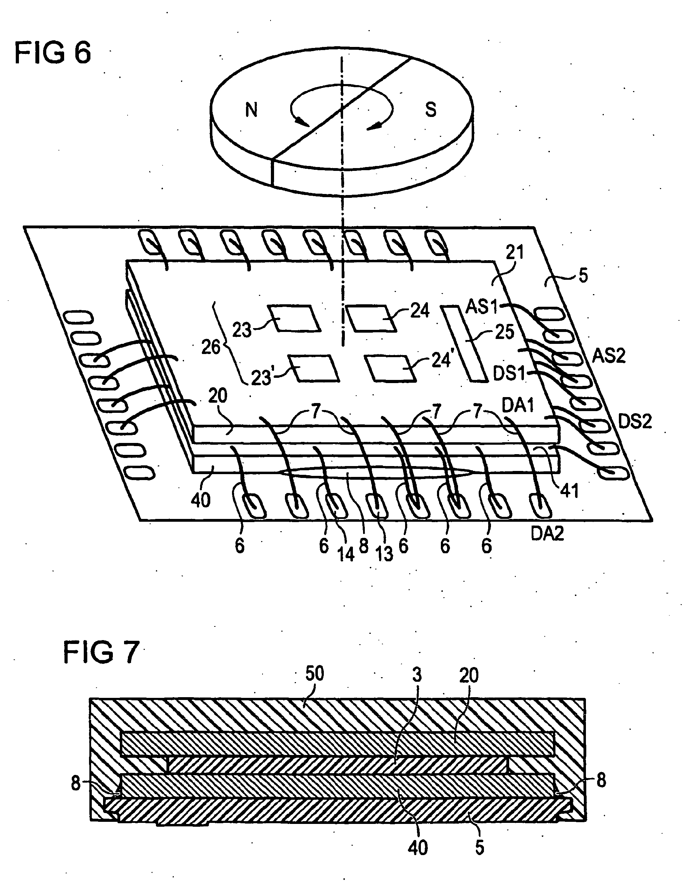

Figur 6 zeigt in einer dreidimensionalen Ansicht als beispielhafte Weiterbildung des Querschnittes in Figur 1 den ersten und den zweiten Magnetfeldsensorkörper 20, 40, die beide als näherungsweise gleich große Körper ausgebildet sind. Die beiden Magnetfeldsensorkörper 20, 40 sind rechteckig ausgebildet und sind mittels eines Abstandskörpers 3, welcher von dem ersten Magnetfeldsensorkörper 20 verdeckt ist, beabstandet.

Bonddrähte 6, 6' verbinden den zweiten Magnetfeldsensorkörper 40 mit Anschlüssen auf dem Trägerkörper 5. Entsprechend verbinden Bonddrähte 7, 7' den ersten Magnetfeldsensorkörper 20 mit Anschlüssen auf dem Trägerkörper 5. Eine Verbindungschicht 8 findet sich nicht nur zwischen dem Trägerkörper 5 und dem zweiten Magnetfeldsensorkörper 40, sondern bedeckt einen Teil der Chipkante des zweiten Magnetfeldsensorkörpers 40. Die Verbindungsschicht 8 ist in dieser beispielhaften Magnetfeldsensoranordnung als Silberleitfähigkeitskleber ausgebildet.

Beide Magnetfeldsensorkörper 20, 40 sind somit in dieser Ansicht mit ihrer jeweils ersten Hauptfläche 21, 41 dem Betrachter zugewandt.

Mit Vorteil sind sowohl der erste Magnetfeldsensorkörper 20 als auch aufgrund des Abstandskörpers 3 der zweite Magnetfeldsensorkörper 40 mit Bonddrähten 6, 6', 7, 7' auf ihrer jeweiligen ersten Hauptseite 21, 41 mit dem Trägerkörper 5 elektrisch leitend verbunden.

Figur 7 zeigt Konturlinien, welche aus einer Fotografie eines Querschliffes extrahiert wurden, welche einen Querschnitt einer beispielhaften Magnetfeldsensoranordnung zeigt. Figur 7 zeigt den ersten Magnetfeldsensorkörper 20, der auf dem Abstandskörper 3 aufgebracht ist. Der Abstandskörper 3 ist wiederum auf dem zweiten Magnetfeldsensorkörper 40 aufgebracht. Der zweite Magnetfeldsensor 40 ist wiederum auf dem Trägerkörper 5 angeordnet. In den Winkeln zwischen dem zweiten Magnetfeldsensorkörper 40 und dem Trägerkörper 5 ist Material der Verbindungsschicht 8, welche sich im Übrigen zwischen diesen beiden Körpern 5, 40 befindet, sichtbar.

In dieser beispielhaften Magnetfeldsensoranordnung ist für die Dicke des Abstandskörpers 3 ein kleinerer Wert als für die Dicke des ersten und des zweiten Magnetfeldsensorkörpers 20, 40 gewählt, wobei letztere beispielsweise 250 µm betragen kann.

Der erste und der zweite Magnetfeldsensorkörper 20, 40 sowie der Abstandskörper 3 sind aus Silizium realisiert. Die in dem Querschnitt gezeigte laterale Abmessung des Abstandskörpers 3 ist geringer als die laterale Abmessung des ersten und des zweiten Magnetfeldsensorkörpers 20, 40.

Die Magnetfeldsensoranordnung ist in einem Quad Flatback No-Lead Logic Packlage 11 gehäust, das ein Polymer 4 aufweist, welches den ersten Magnetfeldsensorkörper 20, den Abstandskörper 3 und den zweiten Magnetfeldsensorkörper 40 umschließt, siehe auch Figur 1.

Mit Vorteil sind somit die beiden Magnetfeldsensorkörper 20, 40 sehr gut eingeschlossen und vor mechanischer Belastung geschützt. Mit Vorteil weist der Abstandskörper 3 dasselbe Material, nämlich Silizium, wie die beiden Magnetfeldsensorkörper 20, 40 auf, sodass er denselben Temperaturkoeffizienten für die Ausdehnung aufweist. Somit verursacht der Abstandskörper 3 bei Temperaturänderungen keinen mechanischen Stress in den beiden Magnetfeldsensorkörpern 20, 40. Mit Vorteil ermöglicht es die verglichen mit den beiden Magnetfeldsensorkörpern 20, 40 kleinere laterale Abmessung des Abstandskörpers 3, dass auch der zweite Magnetfeldsensorkörper 40 mit Bonddrähten kontaktierbar ist.

### Bezugszeichenliste

- 1: Stapelanordnung
- 2: Magnet
- 3: Abstandskörper
- 4: Magnetfeldsensoranordnung
- 5: Trägerkörper
- 6, 6', 7, 7': Bonddraht
- 8: Verbindungsschicht
- 9: Halbleiterkörper
- 10: Verknüpfungsschaltung
- 11: Quad Flatpack No-Lead Logic Package
- 12, 12': Löthöcker
- 13, 14: Anschluss
- 15, 16: Leiterbahn
- 17: Durchkontaktierung
- 18: erste Hauptseite
- 19: zweite Hauptseite
- 20: erster Magnetfeldsensorkörper
- 21: erste Hauptfläche
- 22: zweite Hauptfläche
- 23: erstes magnetfeldsensitives Element
- 23', 24, 24': weiteres magnetfeldsensitives Element
- 25: erste Magnetfeldauswerteschaltung
- 26: erstes Magnetsensorarray
- 27: leitende Verbindung
- 40: zweiter Magnetfeldsensorkörper
- 41: erste Hauptfläche
- 42: zweite Hauptfläche
- 43: zweites magnetfeldsensitives Element
- 44: weiteres magnetfeldsensitives Element
- 45: zweite Magnetfeldauswerteschaltung
- 46: zweites Magnetsensorarray
- 47, 47': leitende Verbindung
- 50: Polymer
- 80, 81: Zwischenschicht
- 82: weitere Verbindungsschicht
- AS1: erstes analoges Signal
- AS2: zweites analoges Signal
- B: Magnetfeld
- D: Abstand
- DIA1: erstes Diagnosesignal
- DIA2: zweites Diagnosesignal
- DS1: erstes digitales Signal
- DS2: zweites digitales Signal
- MS1: erstes magnetfeldabhängiges Signal
- MS2: zweites magnetfeldabhängiges Signal
- N N: Nordpol
- S: Südpol
- Z1, Z2: Abstand

## Patentansprüche

1. Magnetfeldsensoranordnung,
umfassend eine Stapelanordnung (1) mit
- einem ersten Magnetfeldsensorkörper (20) mit einer ersten Hauptfläche (21), an der ein erstes magnetfeldsensitives Element (23) angeordnet ist, einer zweiten Hauptfläche (22), welche zu der ersten Hauptfläche (21) näherungsweise parallel ist, und einer ersten Magnetfeldauswerteschaltung (25), an der ausgangsseitig ein erstes magnetfeldsensitives Signal (MS1) abgreifbar ist und die auf der ersten Hauptfläche (21) des ersten Magnetfeldsensorkörpers (20) angeordnet ist, und
- einem zweiten Magnetfeldsensorkörper (40) mit einer ersten Hauptfläche (41), an der ein zweites magnetfeldsensitives Element (43) angeordnet ist, einer zweiten Hauptfläche (42), welche zu der ersten Hauptfläche (41) näherungsweise parallel ist, und einer zweiten Magnetfeldauswerteschaltung (45), an der ausgangsseitig ein zweites magnetfeldsensitives Signal (MS2) abgreifbar ist und die auf der ersten Hauptfläche (41) des zweiten Magnetfeldsensorkörpers (40) angeordnet ist,
wobei die Stapelanordnung (1) derart realisiert ist, dass der erste Magnetfeldsensorkörper (20) und der zweite Magnetfeldsensorkörper (40) in einer Projektionsrichtung, welche senkrecht zur jeweils ersten Hauptfläche (21, 41) des ersten und des zweiten Magnetfeldsensorkörpers (20, 40) ist, übereinander angeordnet sind.

2. Magnetfeldsensoranordnung nach Anspruch 1,
**dadurch gekennzeichnet, dass**
mindestens ein magnetfeldsensitives Element aus der Gruppe des ersten und des zweiten magnetfeldsensitiven Elementes (23, 43) als Hall-Struktur ausgebildet ist.

3. Magnetfeldsensoranordnung nach Anspruch 1 oder 2,
**dadurch gekennzeichnet, dass**
mindestens ein magnetfeldsensitives Element aus der Gruppe des ersten und des zweiten magnetfeldsensitiven Element (23, 43) als Struktur aus der Gruppe einer Giant-Magnetic-Resistor Struktur und einer Anisotropic-Magnetic-Resistor Struktur ausgebildet ist.

4. Magnetfeldsensoranordnung nach einem der Ansprüche 1 bis 3,
**dadurch gekennzeichnet, dass**
der erste Magnetfeldsensorkörper (20) ein erstes Magnetsensorarray (26) aufweist, welches das erste magnetfeldsensitive Element (23) und mindestens ein weiteres magnetfeldsensitives Element (24) umfasst, oder der zweite Magnetfeldsensorkörper (40) ein zweites Magnetsensorarray (46) aufweist, welches das zweite magnetfeldsensitive Element (43) und mindestens ein weiteres magnetfeldsensitives Element (44) umfasst.

5. Magnetfeldsensoranordnung nach einem der Ansprüche 1 bis 4,
**dadurch gekennzeichnet, dass**
die Stapelanordnung (1) einen Abstandskörper (3) umfasst, der zwischen dem ersten Magnetfeldsensorkörper (20) und dem zweiten Magnetfeldsensorkörper (40) angeordnet ist.

6. Magnetfeldsensoranordnung nach einem der Ansprüche 1 bis 5,
**dadurch gekennzeichnet, dass**
die Stapelanordnung (1) einen Trägerkörper (5) umfasst, der zwischen dem ersten Magnetfeldsensorkörper (20) und dem zweiten Magnetfeldsensorkörper (40) angeordnet ist oder der an einer Hauptfläche aus der Gruppe der Hauptfläche (41, 42) des zweiten Magnetfeldsensorkörpers (40), welche weiter von dem ersten Magnetfeldsensorkörper (20) entfernt ist, und der Hauptfläche (21, 22) des ersten Magnetfeldsensorkörpers (20), welche weiter von dem zweiten Magnetfeldsensorkörper (40) entfernt ist, angeordnet ist.

7. Magnetfeldsensoranordnung nach einem der Ansprüche 1 bis 6,
**dadurch gekennzeichnet, dass**
mindestens ein Magnetfeldsensorkörper aus der Gruppe des ersten Magnetfeldsensorkörpers (20) und des zweiten Magnetfeldsensorkörpers (40) eine leitende Verbindung (27) von der ersten zu der zweiten Hauptfläche (21, 22, 41, 42) durch den ersten beziehungsweise den zweiten Magnetfeldsensorkörper (20, 40) hindurch umfasst.

8. Magnetfeldsensoranordnung nach einem der Ansprüche 1 bis 7,
**dadurch gekennzeichnet, dass**
- an der ersten Magnetfeldauswerteschaltung (25) ausgangsseitig mindestens ein erstes magnetfeldsensitives Signal (MS1) aus der Gruppe eines ersten digitalen Signals (DS1) und eines ersten analogen Signals (AS1) abgreifbar ist, und
- an der zweiten Magnetfeldauswerteschaltung (45) ausgangsseitig mindestens ein zweites magnetfeldsensitives Signal (MS2) aus der Gruppe eines zweiten digitalen Signals (DS2) und eines zweiten analogen Signals (AS2) abgreifbar ist,
wobei die Magnetfeldsensoranordnung (4) einen weiteren Halbleiterkörper (9) mit einer Verknüpfungsschaltung (10) umfasst, die eingangsseitig mit mindestens einem Ausgang der ersten Magnetfeldauswerteschaltung (25) des ersten Magnetfeldsensorkörpers (20) und mit mindestens einem Ausgang der zweiten Magnetfeldauswerteschaltung (45) des zweiten Magnetfeldsensorkörpers (40) gekoppelt ist.

9. Verwendung einer Magnetfeldsensoranordnung nach einem der Ansprüche 1 bis 8 zur berührungslosen Messung des Magnetfeldes (B) eines rotierenden Magneten (2) für eine Drehwinkelbestimmung .

10. Verwendung einer Magnetfeldsensoranordnung nach einem der Ansprüche 1 bis 8 zur berührungslosen Messung des Magnetfeldes (B) eines Magneten aus der Gruppe der zylindrischen Magneten und der stabförmigen Magneten.

11. Verfahren zur berührungslosen Messung eines Magnetfeldes (B) mittels zweier gestapelter Magnetfeldsensorkörper (20, 40), umfassend folgende Schritte:
- Bestimmen des Magnetfeldes (B) mittels eines ersten Magnetfeldsensorkörpers (20) und Abgeben eines ersten magnetfeldabhängigen Signals (MS1) mittels einer ersten Magnetfeldauswerteschaltung (25) des ersten Magnetfeldsensorkörpers (20) derart, dass ein erstes magnetfeldsensitives Element (23) und die erste Magnetfeldauswerteschaltung (25) auf einer ersten Hauptfläche (21) des ersten Magnetfeldsensorkörpers (20) angeordnet sind, und
- Bestimmen des Magnetfeldes (B) mittels eines zweiten Magnetfeldsensorkörpers (40) und Abgeben eines zweiten magnetfeldabhängigen Signals (MS2) mittels einer zweiten Magnetfeldauswerteschaltung (45) des zweiten Magnetfeldsensorkörpers (40) derart, dass ein zweites magnetfeldsensitives Element (43) und die zweite Magnetfeldauswerteschaltung (45) auf einer ersten Hauptfläche (41) des zweiten Magnetfeldsensorkörpers (40) angeordnet sind,
wobei der erste und der zweite Magnetfeldsensorkörper (20, 40) derart gestapelt sind, dass der erste Magnetfeldsensorkörper (20) und der zweite Magnetfeldsensorkörper (40) in einer Projektionsrichtung, welche senkrecht zur jeweils ersten Hauptfläche (21, 41) des ersten und des zweiten Magnetfeldsensorkörpers (20, 40) ist, übereinander angeordnet sind.

12. Verfahren nach Anspruch 11,
**gekennzeichnet durch**
- Abgeben mindestens des ersten magnetfeldabhängigen Signals (MS1) aus der Gruppe eines ersten digitalen Signals (DS1) und eines ersten analogen Signals (AS1) und
- Abgeben mindestens des zweiten magnetfeldabhängigen Signals (MS2) aus der Gruppe eines zweiten digitalen Signals (DS2) und eines zweiten analogen Signals (AS2).

13. Verfahren nach Anspruch 12,
**gekennzeichnet durch**
Zuleiten des ersten magnetfeldabhängigen Signals (MS1) und des zweiten magnetfeldabhängigen Signals (MS2) an eine Verknüpfungsschaltung (10) und Bereitstellen einer Winkelinformation ausgangsseitig an der Verknüpfungsschaltung (10).

14. Verfahren nach Anspruch 12 oder 13,
**gekennzeichnet durch**
Zuleiten des ersten und des zweiten digitalen Signals (DS1, DS2) und des ersten und des zweiten analogen Signals (AS1, AS2) an die Verknüpfungsschaltung (10), Vergleichen der vier Signale mittels der Verknüpfungsschaltung (10) und Bereitstellen der Winkelinformation aus drei der vier Signale.

15. Verfahren nach einem der Ansprüche 11 bis 14,
**gekennzeichnet durch**
Abgeben eines ersten betriebszustandsabhängigen Diagnosesignals (DIA1) **durch** die erste Magnetfeldauswerteschaltung (25) und Abgeben eines.zweiten betriebszustandsabhängigen Diagnosesignals (DIA2) **durch** die zweite Magnetfeldauswerteschaltung (45) sowie Bereitstellen der Winkelinformation unter Berücksichtigung des ersten und des zweiten betriebszustandsabhängigen Diagnosesignals (DIA1, Da2).

## Claims

1. A magnetic field sensor device,
comprising a stack arrangement (1) with
- a first magnetic field sensor body (20) having a first main surface (21) on which a first magnetosensitive element (23) is arranged, a second main surface (22) which is approximately parallel to the first main surface (21), and a first magnetic field evaluation circuit (25) which has an output side at which a first magnetosensitive signal (MS1) can be tapped and which is arranged on the first main surface (21) of the first magnetic field sensor body (20), and
- a second magnetic field sensor body (40) having a first main surface (41) on which a second magnetosensitive element (43) is arranged, a second main surface (42) which is approximately parallel to the first main surface (41), and a second magnetic field evaluation circuit (45) which has an output side on which a second magnetosensitive signal (MS2) can be tapped and which is arranged on the first main surface (41) of the second magnetic field sensor body (40),
the stack arrangement (1) being realized such that the first magnetic field sensor body (20) and the second magnetic field sensor body (40) being arranged one above the other in a direction of projection which is perpendicular to each of the first main surfaces (21, 41) of the first and second magnetic field sensor bodies (20, 40).

2. The magnetic field sensor device according to claim 1,
**characterized in that**
at least one magnetosensitive element from the group of the first and second magnetosensitive elements (23, 43) is formed as a Hall structure.

3. The magnetic field sensor device according to claim 1 or 2,
**characterized in that**
at least one magnetosensitive element from the group of the first and second magnetosensitive elements (23, 43) is formed as a structure from the group of a giant magnetic resistor structure and an anisotropic magnetic resistor structure.

4. The magnetic field sensor device according to any of the claims 1 to 3,
**characterized in that**
the first magnetic field sensor body (20) comprises a first magnet sensor array (26) including the first magnetosensitive element (23) and at least one further magnetosensitive element (24), or the second magnetic field sensor body (40) comprises a second magnet sensor array (46) including the second magnetosensitive element (43) and at least one further magnetosensitive element (44).

5. The magnetic field sensor device according to any of the claims 1 to 4,
**characterized in that**
the stack arrangement (1) includes a spacer (3) which is arranged between the first magnetic field sensor body (20) and the second magnetic field sensor body (40).

6. The magnetic field sensor device according to any of the claims 1 to 5,
**characterized in that**
the stack arrangement (1) includes a carrier body (5) which is arranged between the first magnetic field sensor body (20) and the second magnetic field sensor body (40), or which is arranged on a main surface from the group of the main surface (41, 42) of the second magnetic field sensor body (40), which is situated further away from the first magnetic field sensor body (20), and the main surface (21, 22) of the first magnetic field sensor body (20) which is situated further away from the second magnetic field sensor body (40).

7. The magnetic field sensor device according to any of the claims 1 to 6,
**characterized in that**
at least one magnetic field sensor body from the group of the first magnetic field sensor body (20) and the second magnetic field sensor body (40) includes a conductive connection (27) from the first to the second main surface (21, 22, 41, 42), leading through the first and second magnetic field sensor body (20, 40), respectively.

8. The magnetic field sensor device according to any of the claims 1 to 7,
**characterized in that**
- at least a first magnetosensitive signal (MS1) from the group of a first digital signal (DS1) and a first analogue signal (AS1) can be tapped at the output side of the first magnetic field evaluation circuit (25), and
- at least a second magnetosensitive signal (MS2) from the group of a second digital signal (DS2) and a second analogue signal (AS2) can be tapped at the output side of the second magnetic field evaluation circuit (45),
the magnetic field sensor device (4) including a further semiconductor body (9) with an interconnecting circuit (10) which has its input side coupled with at least one output of the first magnetic field evaluation circuit (25) of the first magnetic field sensor body (20) and with at least one output of the second magnetic field evaluation circuit (45) of the second magnetic field sensor body (40).

9. Use of a magnetic field sensor device according to any of the claims 1 to 8 for the contact-free measurement of the magnetic field (B) of a rotating magnet (2) for determining an angle of rotation.

10. Use of a magnetic field sensor device according to any of the claims 1 to 8 for the contact-free measurement of the magnetic field (B) of a magnet from the group of the cylindrical magnets and bar-shaped magnets.

11. A method for the contact-free measuring of a magnetic field (B) by means of two stacked magnetic field sensor bodies (20, 40), including the following steps:
- determining the magnetic field (B) by means of a first magnetic field sensor body (20) and delivering a first magnetic field dependent signal (MS1) by a first magnetic field evaluation circuit (25) of the first magnetic field sensor body (20) in such a manner that a first magnetosensitive element (23) and the first magnetic field evaluation circuit (25) are arranged on a first main surface (21) of the first magnetic field sensor body (20), and
- determining the magnetic field (B) by means of a second magnetic field sensor body (40) and delivering a second magnetic field dependent signal (MS2) by a second magnetic field evaluation circuit (45) of the second magnetic field sensor body (40) in such a manner that a second magnetosensitive element (43) and the second magnetic field evaluation circuit (45) are arranged on a first main surface (41) of the second magnetic field sensor body (40),
the first and second magnetic field sensor bodies (20, 40) being stacked such that the first magnetic field sensor body (20) and the second magnetic field sensor body (40) are arranged one above the other in a direction of projection which is perpendicular to each of the first main surfaces (21, 41) of the first and second magnetic field sensor body (20, 40), respectively.

12. The method according to claim 11,
**characterized by**
- delivering at least the first magnetic field dependent signal (MS1) from the group of a first digital signal (DS1) and a first analogue signal (AS1) and
- delivering at least the second magnetic field dependent signal (MS2) from the group of a second digital signal (DS2) and a second analogue signal (AS2).

13. The method according to claim 12,
**characterized by**
supplying the first magnetic field dependent signal (MS1) and the second magnetic field dependent signal (MS2) to an interconnecting circuit (10) and providing an angular information at the output side of the interconnecting circuit (10).

14. The method according to claim 12 or 13,
**characterized by**
supplying the first and second digital signals (DS1, DS2) and the first and second analogue signals (AS1, AS2) to the interconnecting circuit (10), comparing the four signals by means of the interconnecting circuit (10) and providing the angular information from three of the four signals.

15. The method according to any of the claims 11 to 14,
**characterized by**
delivering a first operation state dependent diagnose signal (DIA1) by the first magnetic field evaluation circuit (25) and delivering a second operation state dependent diagnose signal (DIA2) by the second magnetic field evaluation circuit (45) as well as providing the angular information with consideration of the first and second operation state dependent diagnose signals (DIA1, DIA2).

## Revendications

1. Dispositif de détection de champ magnétique,
comprenant un empilement (1) avec
- un premier corps de détection de champ magnétique (20) présentant une première surface principale (21) sur laquelle se trouve un premier élément sensible au champ magnétique (23), une seconde surface principale (22) approximativement parallèle à la première surface principale (21), et un premier circuit d'évaluation de champ magnétique (25) en sortie duquel un premier signal sensible au champ magnétique (MS1) peut être prélevé et qui est disposé sur la première surface principale (21) du premier corps de détection de champ magnétique (20), et
- un second corps de détection de champ magnétique (40) présentant une première surface principale (41) sur laquelle se trouve un second élément sensible au champ magnétique (43), une seconde surface principale (42) approximativement parallèle à la première surface principale (41), et un second circuit d'évaluation de champ magnétique (45) en sortie duquel un second signal sensible au champ magnétique (MS2) peut être prélevé et qui est disposé sur la première surface principale (41) du second corps de détection de champ magnétique (40), l'empilement (1) étant réalisé de telle façon que le premier corps de détection de champ magnétique (20) et le second corps de détection de champ magnétique (40) sont superposés dans un sens de projection qui est respectivement perpendiculaire à la première surface principale (21, 41) du premier et du second corps de détection de champ magnétique (20, 40).

2. Dispositif de détection de champ magnétique selon la revendication 1,
**caractérisé en ce que**
au moins un élément sensible au champ magnétique issu du groupe du premier et du second élément sensible au champ magnétique (23, 43) est constitué comme structure de Hall.

3. Dispositif de détection de champ magnétique selon la revendication 1 ou 2,
**caractérisé en ce que**
au moins un élément sensible au champ magnétique issu du groupe du premier et du second élément sensible au champ magnétique (23, 43) est constitué comme structure issue du groupe d'une structure à résistance magnétique géante (*Giant-Magnetic-Resistor*) et d'une structure à résistance magnétique anisotropique (*Anisotropic-Magnetic-Resistor*).

4. Dispositif de détection de champ magnétique selon l'une des revendications 1 à 3,
**caractérisé en ce que**
le premier corps de détection de champ magnétique (20) présente un premier ensemble de détection magnétique (26) qui comprend le premier élément sensible au champ magnétique (23) et au moins un autre élément sensible au champ magnétique (24), ou bien le second corps de détection de champ magnétique (40) présente un second ensemble de détection magnétique (46) qui comprend le second élément sensible au champ magnétique (43) et au moins un autre élément sensible au champ magnétique (44).

5. Dispositif de détection de champ magnétique selon l'une des revendications 1 à 4,
**caractérisé en ce que**
l'empilement (1) comporte un corps d'espacement (3) qui est disposé entre le premier corps de détection de champ magnétique (20) et le second corps de détection de champ magnétique (40).

6. Dispositif de détection de champ magnétique selon l'une des revendications 1 à 5,
**caractérisé en ce que**
l'empilement (1) comporte un corps-support (5) qui est disposé entre le premier corps de détection de champ magnétique (20) et le second corps de détection de champ magnétique (40) ou qui est disposé sur une surface principale issue du groupe de la surface principale (41, 42) du second corps de détection de champ magnétique (40) qui est davantage éloignée du premier corps de détection de champ magnétique (20), et de la surface principale (21, 22) du premier corps de détection de champ magnétique (20) qui est davantage éloignée du second corps de détection de champ magnétique (40).

7. Dispositif de détection de champ magnétique selon l'une des revendications 1 à 6,
**caractérisé en ce que**
au moins un corps de détection de champ magnétique issu du groupe du premier corps de détection de champ magnétique (20) et du second corps de détection de champ magnétique (40) comporte une liaison conductrice (27) allant de la première à la seconde surface principale (21, 22, 41, 42) et traversant respectivement le premier ou le second corps de détection de champ magnétique (20, 40).

8. Dispositif de détection de champ magnétique selon l'une des revendications 1 à 7,
**caractérisé en ce que**
- au moins un premier signal sensible au champ magnétique (MS1) issu du groupe d'un premier signal numérique (DS1) et d'un premier signal analogique (AS1) peut être prélevé en sortie du premier circuit d'évaluation de champ magnétique (25), et
- au moins un second signal sensible au champ magnétique (MS2) issu du groupe d'un second signal numérique (DS2) et d'un second signal analogique (AS2) peut être prélevé en sortie du second circuit d'évaluation de champ magnétique (45),
le dispositif de détection de champ magnétique (4) comportant un autre corps semi-conducteur (9) ayant un circuit de liaison (10) dont une entrée est couplée à au moins une sortie du premier circuit d'évaluation de champ magnétique (25) du premier corps de détection de champ magnétique (20) et à au moins une sortie du second circuit d'évaluation de champ magnétique (45) du second corps de détection de champ magnétique (40).

9. Utilisation d'un dispositif de détection de champ magnétique selon l'une des revendications 1 à 8 pour la mesure sans contact du champ magnétique (B) d'un aimant rotatif (2) en vue de déterminer un angle de rotation.

10. Utilisation d'un dispositif de détection de champ magnétique selon l'une des revendications 1 à 8 pour la mesure sans contact du champ magnétique (B) d'un aimant issu du groupe des aimants cylindriques et des aimants en forme de barreau.

11. Procédé de mesure sans contact d'un champ magnétique (B) moyennant deux corps de détection de champ magnétique empilés (20, 40), comportant les étapes suivantes :
- détermination du champ magnétique (B) moyennant un premier corps de détection de champ magnétique (20) et émission d'un premier signal dépendant du champ magnétique (MS1) moyennant un premier circuit d'évaluation de champ magnétique (25) du premier corps de détection de champ magnétique (20) de telle façon qu'un premier élément sensible au champ magnétique (23) et le premier circuit d'évaluation de champ magnétique (25) sont disposés sur une première surface principale (21) du premier corps de détection de champ magnétique (20), et
- détermination du champ magnétique (B) moyennant un second corps de détection de champ magnétique (40) et émission d'un second signal dépendant du champ magnétique (MS2) moyennant un second circuit d'évaluation de champ magnétique (45) du second corps de détection de champ magnétique (40) de telle façon qu'un second élément sensible au champ magnétique (43) et le second circuit d'évaluation de champ magnétique (45) sont disposés sur une première surface principale (41) du second corps de détection de champ magnétique (40),
le premier et le second corps de détection de champ magnétique (20, 40) étant empilés de telle façon que le premier corps de détection de champ magnétique (20) et le second corps de détection de champ magnétique (40) sont superposés dans un sens de projection qui est respectivement perpendiculaire à la première surface principale (21, 41) du premier et du second corps de détection de champ magnétique (20, 40).

12. Procédé selon la revendication 11,
**caractérisé par**
- l'émission au moins du premier signal dépendant du champ magnétique (MS1) issu du groupe d'un premier signal numérique (DS1) et d'un premier signal analogique (AS1) et
- l'émission au moins du second signal dépendant du champ magnétique (MS2) issu du groupe d'un second signal numérique (DS2) et d'un second signal analogique (AS2).

13. Procédé selon la revendication 12,
**caractérisé par**
la transmission du premier signal dépendant du champ magnétique (MS1) et du second signal dépendant du champ magnétique (MS2) à un circuit de liaison (10) et la mise à disposition d'une information d'angle en sortie du circuit de liaison (10).

14. Procédé selon la revendication 12 ou 13,
**caractérisé par**
la transmission du premier et du second signal numérique (DS1, DS2) et du premier et du second signal analogique (AS1, AS2) au circuit de liaison (10), la comparaison des quatre signaux moyennant le circuit de liaison (10) et la mise à disposition de l'information d'angle à partir de trois des quatre signaux.

15. Procédé selon l'une des revendications 11 à 14,
**caractérisé par**
l'émission d'un premier signal de diagnostic dépendant de l'état de fonctionnement (DIA1) par le premier circuit d'évaluation de champ magnétique (25) et l'émission d'un second signal de diagnostic dépendant de l'état de fonctionnement (DIA2) par le second circuit d'évaluation de champ magnétique (45) ainsi que la mise à disposition de l'information d'angle compte tenu du premier et du second signal de diagnostic dépendant de l'état de fonctionnement (DIA1, DIA2).
